Europäisches Patentamt

European Patent Office

Office européen des brevets

(11) Publication number: **0 307 237**
**A2**

# EUROPEAN PATENT APPLICATION

(21) Application number: 88308368.5

(22) Date of filing: 09.09.88

(51) Int. Cl.⁴: **H 03 F 3/30**

(30) Priority: 10.09.87 GB 8721329

(43) Date of publication of application:
15.03.89 Bulletin 89/11

(84) Designated Contracting States:
AT BE CH DE ES FR GB GR IT LI LU NL SE

(71) Applicant: INTEGRATED POWER SEMICONDUCTORS
LTD.
MacIntosh Road Kirkton Campus
Livingston EH54 7BW Scotland (GB)

(72) Inventor: Pennock, John Laurence,
39, Baberton Crescent,
Juniper Green, Edinburgh EH14 5BW (GB)

(74) Representative: Pike, Harold John et al
Abel & Imray Northumberland House 303-306 High
Holborn
London, WC1V 7LH (GB)

(54) Signal amplifier.

(57) A signal amplifier including a bridge output stage, a comparator stage arranged to control a first part of the output stage in accordance with the polarity of an input signal, and a modulating stage arranged to control a second part of the output stage in accordance with the magnitude and polarity of the input signal. The signal amplifier is particularly suitable for fabrication as an integrated circuit.

Fig.l.

Description

## SIGNAL AMPLIFIER

The present invention relates to signal amplifiers, particularly amplifiers of control signals for electro-mechanical control.

Signal amplifiers are required in electro-mechanical equipment in which actuators, usually actuators which include a motor coil, are used to effect the movement of a part of the equipment in response to an electrical control signal. An example of electro-mechanical equipment employing an actuator which includes a motor coil is a magnetic storage disc drive arrangement in which a linear actuator is used to position the magnetic reading and writing heads at a particular track of the magnetic disc, and to retract the reading and writing heads.

In accordance with the present invention a signal amplifier includes a bridge-connected output stage, a comparator stage arranged to control a first part of the output stage in accordance with the polarity of an input signal, and a modulating stage arranged to control a second part of the output stage in accordance with the magnitude and polarity of the input signal.

In one form of the amplifier, the arrangement is such that, in operation, the first part of the output stage is switched and the second part of the output stage is conductance modulated.

In one embodiment of the invention, the modulating stage is arranged to control the comparator stage, and, additionally, the comparator stage is arranged to control two arms of the bridge-connected output stage, which may be the upper or the lower arms of the bridge-connected output stage.

Preferably, the amplifier is so arranged that control devices, which may be transistors, forming two arms of the bridge-connected output stage are conductive when the input signal amplitude is zero, and the appropriate one of the control devices becomes non-conductive, according to the input signal polarity, as the input signal deviates from zero magnitude.

In the arrangement in which the control devices forming the previously mentioned, or first, two arms of the bridge-connected output stage are conductive when the input signal is zero, further control devices, which may also be transistors, forming the two further arms of the bridge-connected output stage are both non-conductive when the input signal has zero magnitude, and the appropriate one of the further control devices conducts, according to the input signal polarity and magnitude, as the input signal deviates form zero magnitude, to provide an output signal across a load connected to the amplifier output port.

Preferably, the amplifier is so arranged that each of the further control devices becomes conductive after the first control device located in the opposite arm of the bridge-connected output stage is conductive, as the input signal moves away from zero magnitude.

Preferably, the amplifier output stage includes a biassing network arranged to provide set conditions at the amplifier output port at times when the input signal is such that the states of the control devices would leave the output conditions indeterminate. The biassing network may be arranged to include a low-level current source between the higher level supply voltage terminal and the terminals of the output port, and current bleed paths between the terminals of the output port and the lower level supply voltage terminal.

Preferably the modulating stage is arranged to provide a current dependent on the magnitude of the input signal for driving the output stage.

Preferably, the modulating stage includes a first amplifier network arranged to receive an input signal, a second amplifier network arranged to receive a feedback signal from the output stage, and a summing amplifier network arranged to receive the output signals from the first and second amplifier networks.

Preferably, the amplifier networks are provided with differential-input ports.

In one embodiment of the invention, a feedback network is connected between the output stage and the second amplifier network for amplifier bandwidth control. Suitable bandwidth-setting feedback networks include a purely capacitive network, a capacitor-resistor network, a network including capacitors in combination with buffer amplifiers, or a network including capacitors in combination with current amplifiers.

Preferably, the signal amplifier includes a voltage monitoring network arranged to monitor the amplifier voltage supply and to control a network for effecting shut-down of the amplifier, the monitoring network being arranged to signal the shut-down network when the voltage supply is below a set value, to effect shut-down of the amplifier.

Preferably, the signal amplifier includes a "retract" network arranged to receive supply energy independently of the amplifier voltage supply and to provide energy directly to the amplifier output port when the voltage monitoring network signals that the voltage supply is below the set value, the "retract" network, in operation of the amplifier, being capable of returning an actuator to its start position during conditions when the voltage monitoring network is signalling that the voltage supply is below the set value, and, preferably, the "retract" network is arranged to provide a constant current to the amplifier output port. Such a "retract" network operates to return the actuator to its start position with constant acceleration.

Alternatively, the "retract" network may be arranged to provide a constant voltage (with some current limit) at the amplifier output port, in which case the actuator is returned to its start position at a substantially constant rate.

Preferably, the signal amplifier includes a network arranged to monitor the operating temperature of components of the output stage and to control a network for effecting shut-down of the amplifier, the temperature monitoring network being arranged to signal to the shut-down network when the operating temperature of a component of the output stage exceeds a set level, to effect shut-down of the amplifier, and, the temperature monitoring network may be arranged to also activate the "retract" network.

Advantageously, a bridge-connected output stage, a comparator stage, and a modulating stage are fabricated as a monolithic integrated circuit suitable for constructing the signal amplifier, and, preferably, the monolithic integrated circuit includes not only the bridge-connected output stage, the comparator stage, and the modulating stage, but also a voltage monitoring network and a shut-down network.

Advantageously, the monolithic integrated circuit includes a "retract" network for retracting an actuator under conditions of power supply loss, and, preferably, the monolithic integrated circuit includes a temperature monitoring network for shutting down the amplifier and for activating the "retract" network when the temperature of an output stage component exceeds a set level.

A signal amplifier in accordance with the present invention will now be described by way of example only, and with reference to the accompanying drawings, in which:-

Fig. 1 is a block diagram representation of a signal amplifier, in accordance with the present invention, for driving a linear actuator coil in a magnetic disc drive arrangement,

Fig. 2 is a block diagram representation of a possible arrangement of the input, intermediate, and output amplifying stages of the amplifier of Fig. 1,

Fig. 3 is a block diagram representation of a practical arrangement of the input, intermediate, and output amplifying stages of the amplifier of Fig. 1

Fig. 4 is a more detailed representation of the output stages than is shown in Fig. 3,

Fig. 5 is a diagrammatic representation of the connection of bandwidth-setting components between the input and output stages of the amplifier of Fig. 1,

Fig. 6 is a diagrammatic representation of a "retract" network included in the signal amplifier of Fig. 1,

Fig. 7 is a diagrammatic representation of external arrangements associated with the "retract" network of the signal amplifier of Fig. 1, and,

Fig. 8 is a diagrammatic representation of supply voltage monitoring network included in the signal amplifier of Fig. 1.

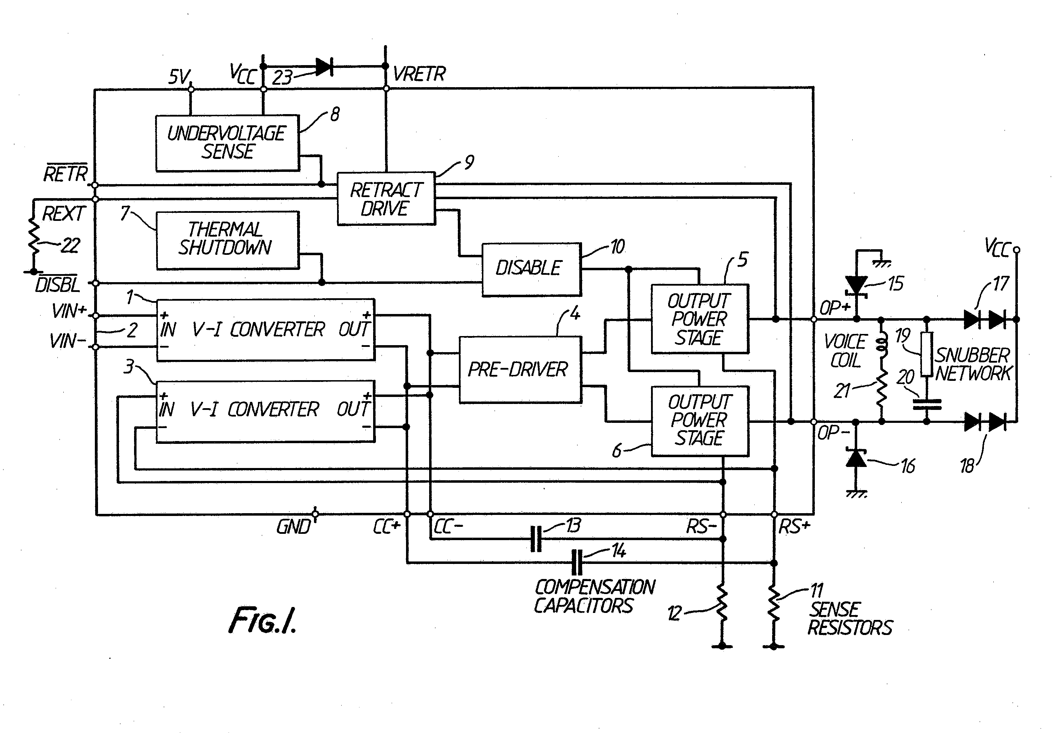

Referring now to Fig. 1, a signal amplifier for driving a linear actuator coil in a magnetic disc drive arrangement includes a first voltage-to-current converter 1 having a control input port 2 which provides the control input port for the signal amplifier, a second voltage-to-current converter 3, a pre-driver stage 4, output power drive stages 5 and 6, a thermal shut-down stage 7, an undervoltage sensing stage 8, a "retract" stage 9, a "disable" stage 10, a current setting resistor 22, current sensing resistors 11 and 12, and bandwidth setting capacitors 13 and 14. Shown also in Fig. 1 are reverse current and voltage clamping components 15, 16, 17 and 18, and a snubber network 19 and 20, associated with a coil 21 connected to the output power drive stages 5 and 6 of the signal amplifier. The coil 21, known as a voice coil, represents the coil of a linear actuator for moving the writing and reading heads of a magnetic disc drive arrangement. The "retract" state 9 is energised externally through a supply voltage input port VRETR connected, in Fig. 1, to the general supply voltage input port Vcc through a diode 23.

In the operation of the signal amplifier of Fig. 1, the control input voltage applied to the input port 2 is converted into a current by means of the first voltage-to-current converter 1. A measure of the actual output current of the amplifier is provided by the current sensing resistors 11 and 12, connected to respective ones of the output power drive stages 5 and 6, and the voltage developed across the current sensing resistors is used to control the second voltage-to-current converter 3. The voltage-to-current converters 1 and 3 provide drive power for the pre-driver stage 4 the output current from which is amplified by the output power drive stages 5 and 6 which provide the output port of the signal amplifier. The thermal shut-down stage 7 is arranged to operate through the "disable" stage 10 to shut down the output power drive stages 5 and 6 in the event that the junction temperature of an output stage device exceeds a desired operating temperature for that device. The undervoltage sensing stage 8 responds to a low voltage condition at any of the power supply input ports by activating the "retract" stage 9, and the "disable" stage 10 operates to force each of the output power drive stages 5 and 6 to a zero output current state when its control input port (DISABLE) is held at a low voltage. The resistor 22 sets the current which the "retract" stage 9 is able to supply to the amplifier output port to energise the coil 21 when the "retract" function is executed. The supply voltage input port VRETR is available for connection to the winding of a rotary drive motor used elsewhere in the disc drive arrangement, for example the spindle motor, in order to use the spindle motor as an energy source for energising the coil 21 under supply voltage loss conditions. The diode 23 ensures that the voltage level is high at the input port VRETR, at switch-on, and also permits the "retract" stage 9 to be energised by the general supply voltage in order that the "retract" stage may be used to perform the retract function under normal operating conditions. In normal operating conditions, that is, in the absence of an undervoltage condition, the "retract" stage 9 may be activated by means of the appropriate signal applied to the RETR input port in order to effect the return of an actuator controlled by the amplifier to its start position. The signal for causing the execution of the retract function during normal operating conditions will be provided by the external control system for the amplifier.

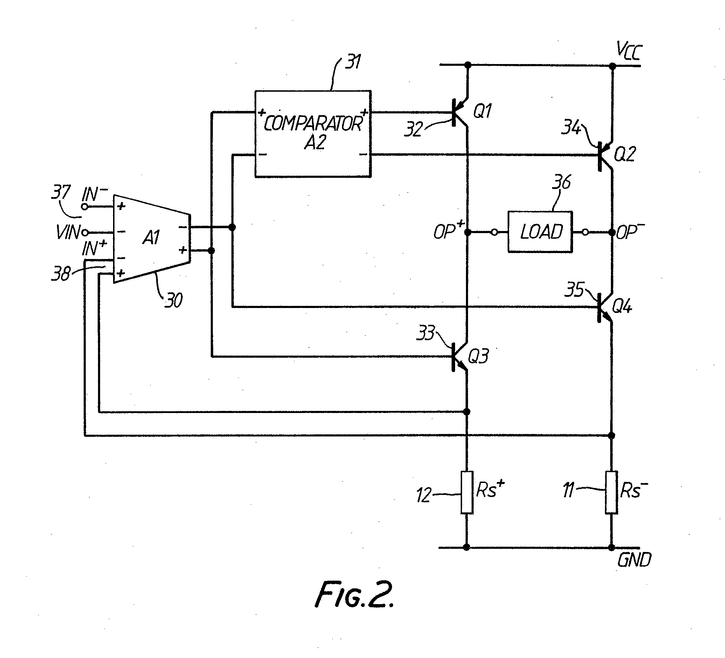

Referring to Fig. 2, the signal amplifier of Fig. 1 includes, at a minimum, an input amplifier stage 30 having a first input port 37 and a second input port 38, a comparator stage 31 the input port of which is connected to the output port of the input amplifier stage 30, a bridge-connected output stage consisting of transistors 32 to 35, and output current sensing resistors 11 and 12 connected in the emitter circuits of the transistors 33 and 35. A load coil 36 is shown connected to the output port of the amplifier.

Referring again to Fig. 2, in operation, the amplifier is driven by the signal applied to the input port 37 and by the fed back signal from the resistors 11 and 12, which fed back signal is applied to the input port 38 of the amplifier 30. The amplifier 30 generates an output signal dependent on the difference between the signal applied to the input port 37 and the fed back signal applied to the input port 38. The output signal from the amplifier 30 is such as to switch on either the transistors 32 and 35, as a pair, to drive current in one direction through the load 36, or to switch on the transistors 33 and 34, as a pair, to drive current in the other direction through the load 36. The output signal from the comparator 31 is such as to cause either the transistor 32, or the transistor 34, to become fully conductive, while the output signal of the amplifier 30 is such as to cause either the transistor 33, or the transistor 35, to regulate the current flow. At the zero output current condition, both the transistors 32 and 34 are switched on and both the transistors 33 and 35 are switched off. When an input signal at the input port 37 appears, either the transistor 32 or the transistor 34 will be switched off and the appropriate one of the transistors 33 and 34 will be switched on. The transistors 33 and 35 are so biassed as to give a small dead-band during conduction switch-over in order to avoid shoot-through current at switch-over. The transistors are shown as single devices but may be compound devices where high supply voltages are to be used or improved current control is required.

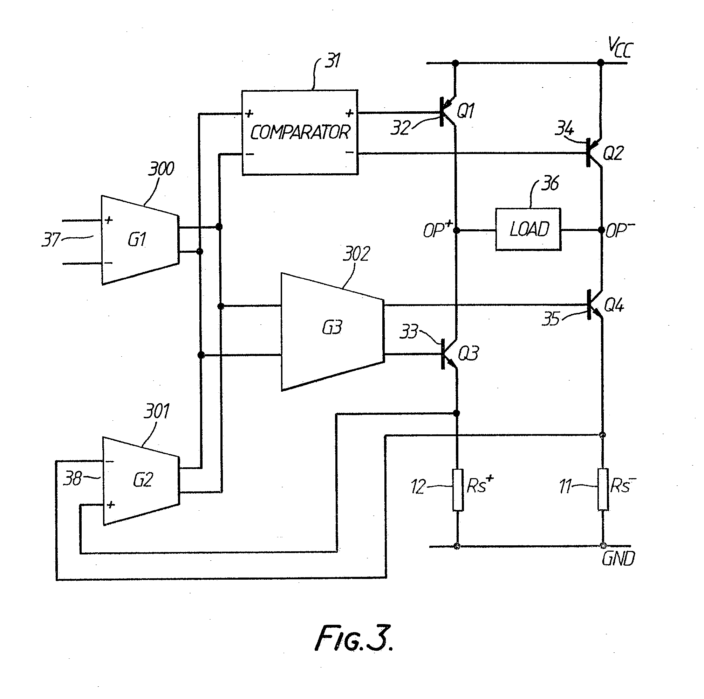

Referring to Fig. 3, which represents a more practical form of the signal amplifier shown in Fig. 2, the coil-driving amplifier comprises two transconductance amplifier stages 300 and 301, an intermediate amplifier stage 302, the comparator 31, the transistors 32 to 35, and the current sensing resistors 11 and 12. The input control voltage applied to the input port 37 of the transconductance amplifier 300 is summed with the fed back signal applied to the input port 38 of the transconductance amplifier 301 (with due attention being paid to the relative polarities of the signals), and the resulting signal is used to provide the modulating current for the transistors 33 and 35 by way of the intermediate amplifier 302. The transconductance of the amplifier 301 is larger than that of the amplifier 300, the ratio of these two transconductances determining the ratio of the input voltage to the input port 37 to the fed back voltage to the input port 38. For example, if it is required that the maximum input voltage to the input port 37 should be of the order of 3 volts (differential input) and the fed back voltage should not exceed .6 volts, then the ratio of the transconductance of the amplifiers 301 and 300 will be 5:1. It is, of course, advantageous to arrange for operation with a small fed-back voltage since the fed-back voltage represents a loss in output voltage. For the proposed 5:1 ratio of the transconductance of the amplifier 301 to that of the amplifier 300, the overall transconductance will be $.2/R_{sense}$, providing a transconductance of the order of 1 amp/volt when $R_{sense}$ is of the order of .2 ohm, where $R_{sense}$ is the value of the resistor 11 or the resistor 12. The differential input arrangement to the amplifier 301 acts to suppress common mode noise generated by the resistors 11 and 12. The amplifier 300 may be operated either as a differential or single-ended input amplifier provided that due attention is paid to any input voltage restrictions imposed by the biassing conditions. The amplifier 302 is included in order to increase the open loop gain and thereby reduce the closed loop cross-over distortion of the signal amplifier.

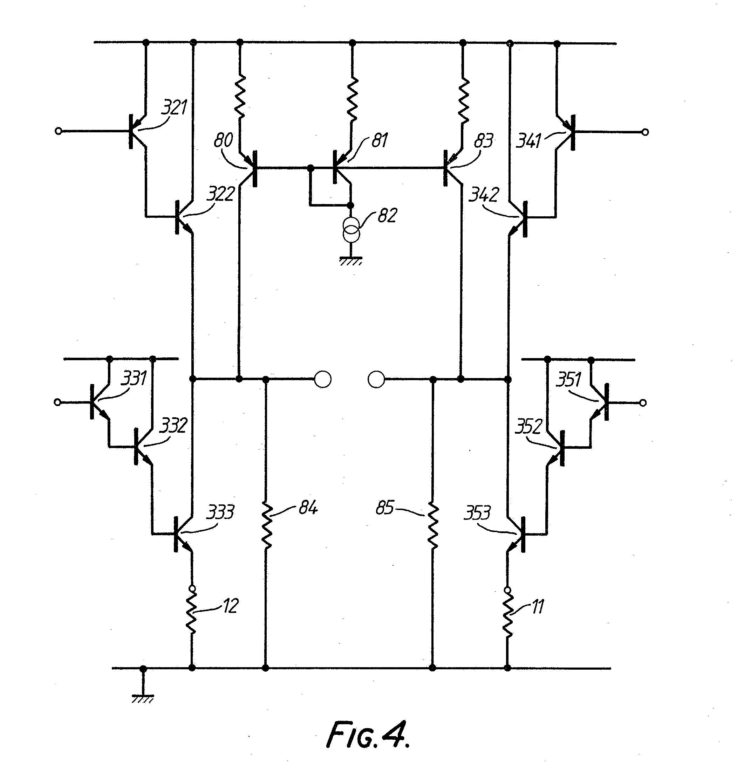

A form of the bridge-connected output stage is shown in some detail in Fig. 4, in which the compound transistors 321-322 and 341-342 provide the two upper arms of the bridge and the compound transistors 331-332-333 and 351-352-353 provide the two lower arms of the bridge. The resistors 11 and 12 are the externally connected current sensing resistors already shown in Figs. 1 to 3. The transistors 80, 81 and 83 along with their associated emitter electrode resistors and the current source 82 provide a low-level current feed to the output port of the bridge network and, with the resistors 84 and 85, serve to establish set voltage conditions at the output port particularly when the devices forming the bridge are all non-conductive as is the case when the disable function is operative. Additionally, the low current supplied to the output port effects some pull-up at the terminals of the output port during transient operating conditions as each of the devices forming the lower arms of the bridge changes from a conductive to a non-conductive state, and the resistors 84 and 85 serve to oppose the generation of a positive spike as each of the devices forming the upper arms of the bridge changes from a non-conductive to a conductive state.

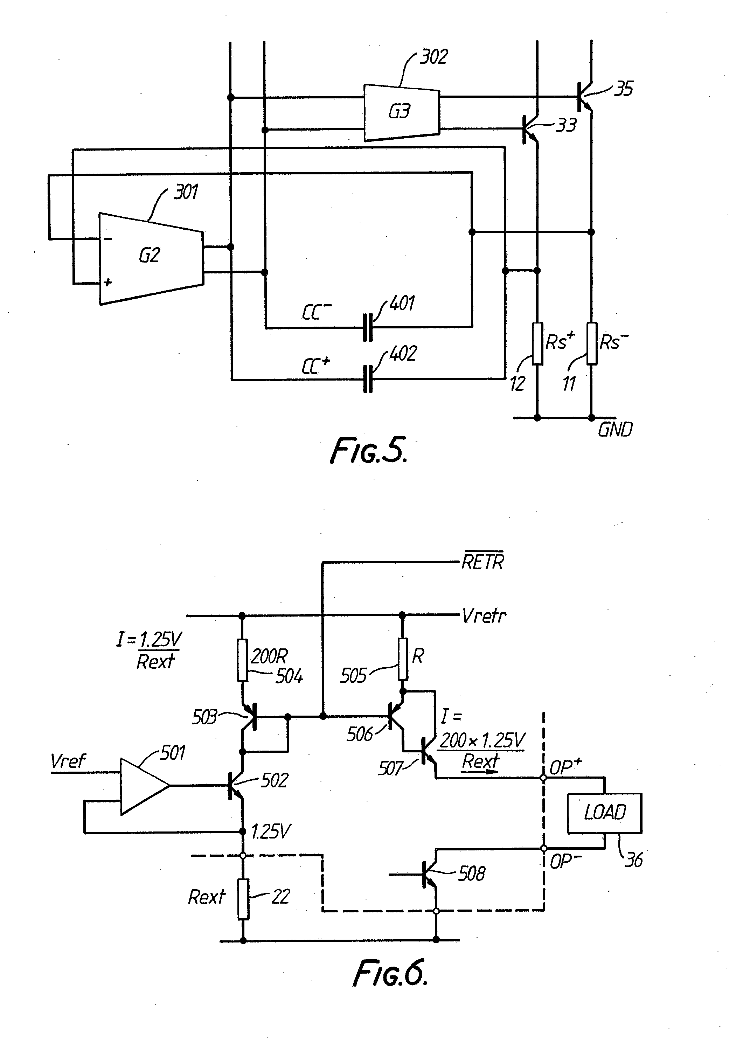

Referring to Fig. 5, bandwidth control and control loop stabilisation are effected by means of two capacitors 401 and 402, connected between the output port of the transconductance amplifier 301 and the current-sensing resistors 11 and 12. The current control loop formed by the amplifiers 301 and 302, the transistors 33 and 35, and the current sensing resistors 11 and 12, is stabilised by the capacitors 401 and 402 which introduce high-frequency negative feedback to the amplifier 302 in a way similar to Miller stabilisation of an operational amplifier. The gain of the loop falls to unity (the-3dB point of transconductance) when the current fed back through either the capacitor 401 or the capacitor 402, that is, according to which of the transistors 33 and 35 is active, is equal to the current output from the amplifier 301. Alternatives to the purely capacitive feedback provided by the capacitors 401 and 402 include resistor-capacitor combinations (resulting in the alteration of the phase margin/transient response by killing higher frequency feedback), the use of a buffer stage to reduce the capacitive loading effect of the capacitors 401 and 402 (resulting in reduced crossover distortion), and the use of a current amplifier to reduce the values of the capacitors 401 and 402.

Fig. 6 illustrates an arrangement suitable for executing the "retract" operation as controlled by the signal present on the $\overline{\text{RETR}}$ input port. For the arrangement illustrated by Fig. 6, a high level input voltage applied to the $\overline{\text{RETR}}$ input port will keep the transistors 504 and 505 switched off, and, although not evident from the base drive arrangements shown for it, the transistor 508 will be switched off. A low level input voltage applied to the $\overline{\text{RETR}}$ input port will cause the transistors 504, 505 and 508 to conduct, with the result that current will pass through the current sources consisting of the resistor 505 and the transistors 506 and 507, to the load coil 36 and through the transistor 508. The current passing through the current source 505-506-507 is set by the components 501, 502, 503, 504 which represent a bandgap reference providing a reference voltage which, on application to the resistor 22, generates a reference current, which reference current is multipled through a current mirror which supplies the load current. In the instance where the reference voltage is P volts, the resistor 22 has a value of Q ohms, and the current multiplication is R, then the available load current is PR/Q amps. Suitable values for P, Q, and R are, respectively, 1.25 volts, 1KΩ, and 200, in which case the available load current is 250 mA. Practical considerations require that the value of the resistor 22 should not be so small as to permit such flow as to cause the current capacity of either the transistor 507 or the transistor 508 be exceeded, or to cause the voltage developed across the load to back bias the current mirror 505-506-507 excessively. The $\overline{\text{RETR}}$ input is arranged also to disable the normal drive to the output stage, but this is not shown in Fig. 6.

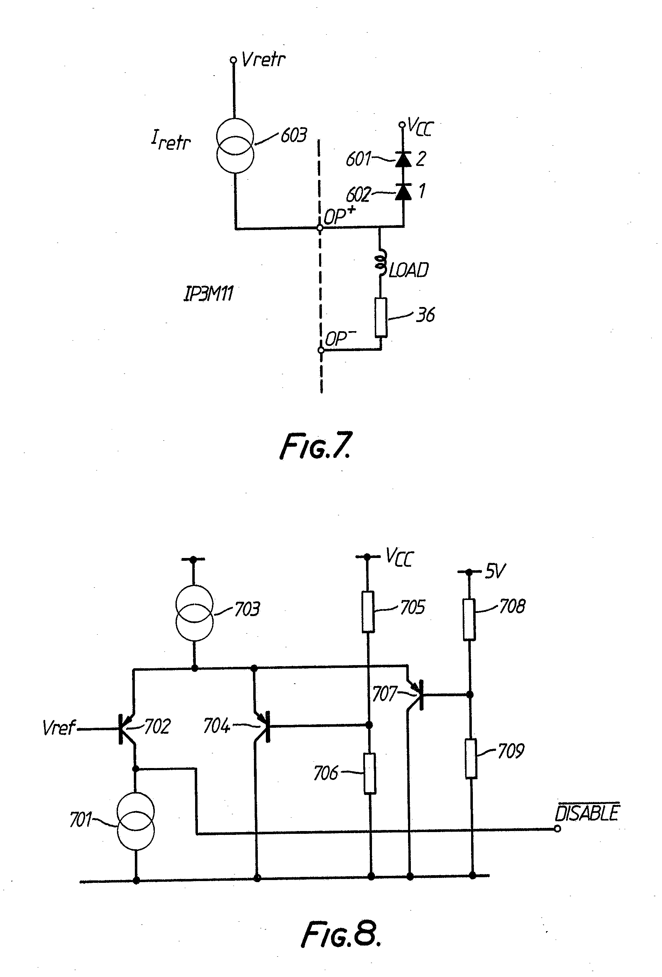

Referring to Fig. 7, the current source output stage of Fig. 6, represented as a current source in Fig. 7, is shown driving the load coil 36, with clamping diodes 601 and 602 connecting the load coil 36 to the positive side of the voltage supply. The diodes 601 and 602 are present because they are required during normal operation in order to protect the output stages devices from transient conditions which would otherwise damage them. The presence of two diodes 601 and 602 ensures that the voltage level at the load 36 is not held too low in the circumstances where the voltage supply is not at its nominal value or has been lost, that is, zero.

Fig. 8 illustrates the undervoltage detection arrangements for the signal amplifier. Sample values of the voltage supplies being monitored are obtained by the potential divider chains 705-706 and 708-709, respectively, and compared with a reference voltage by means of the comparator comprising the transistors 702, 704 and 707, and the current sources 701 and 703. An undervoltage condition for one or both of the supply voltages gives rise to an internal DISABLE signal which switches off the output stage of the signal amplifier. The undervoltage detection arrangements include significant hysteresis in order to prevent reactivation of the output stages when the supply voltage deviates from the detection threshold by small amounts during undervoltage conditions. The existence of undervoltage conditions also gives rise to a $\overline{\text{RETR}}$ signal, as will be evident from Fig. 1, to bring into operation the circuit represented by Fig. 6.

The major components of the signal amplifier represented by Fig. 1, that is, the voltage-to-current converters 1 and 3, the undervoltage sensing circuit 8, the thermal shutdown circuit 7, the retract drive circuit 9, the disable circuit 10, the pre-driver stage 4, and the output stages 5 and 6 are so configured as to be particularly suitable for implementation as a single monolithic integrated circuit.

The amplifier described above is particularly suitable for driving voice-coil disc head positioning actuators for magnetic storage disc drives, but may be used also for controlling actuators in similar bidirectional position or velocity control systems. The amplifier is capable of providing output current which is insensitive to the load impedance, the time constant of the load, or the back-emf generated by the load. The amplifier bandwidth is controlled by user selectable networks which may include only capacitors. Small signal bandwidths of the order of 20 kHz or more may be achieved, providing minimal phase lag in practical actuations. The device is capable of delivering ± 3 amps output current for a ± 3 volts input signal when energised by a 12 volt supply. When the amplifier is used for disc-head actuator control, the head retract function is executed when a low voltage appears at the power supply input port because of the action of the internal circuitry to pull down the $\overline{\text{RETR}}$ input signal, and the amplifier is arranged to use energy from the spindle motor to effect head retraction under such supply voltage conditions.

The signal amplifier arrangements, in respect of the execution of the "retract" function, may be varied. For example, the network for performing the undervoltage sensing function need not be included within the signal amplifier, in which case an additional external network would be required to perform the undervoltage sensing function and such a network would be connected externally to the retract drive network by way of the $\overline{\text{RETR}}$ input port. Where the amplifier control system includes a network, which may be a logic network, for signalling to the $\overline{\text{RETR}}$ input port in order to effect the "retract" function as one of the normal operating functions of the amplifier, the external undervoltage sensing network may be merged with the network for signalling the "retract" function.

## Claims

1. A signal amplifier which includes a bridge-connected output stage, a comparator stage arranged to control a first part of the output stage in accordance with the polarity of an input signal, and a modulating stage arranged to control a second part of the output stage in accordance with the magnitude and polarity of the input signal.

2. A signal amplifier as claimed in claim 1, in which the modulating stage is arranged to control the comparator stage.

3. A signal amplifier as claimed in claim 1 or claim 2, in which the comparator stage is arranged to control two arms of the bridge-connected output stage.

4. A signal amplifier as claimed in claim 3, which is so arranged that control devices forming the two arms of the bridge-connected output stage are conductive when the input signal amplitude is zero, and the appropriate one of the control devices becomes non-conductive, according to the input signal polarity, as the input signal deviates from zero magnitude.

5. A signal amplifier as claimed in claim 4, wherein further control devices forming the two further arms of the bridge-connected output stage are both non-conductive when the input signal has zero magnitude, and the appropriate one of the further control devices conducts, according to the input signal polarity and magnitude, as the input signal deviates from zero magnitude.

6. A signal amplifier as claimed in claim 5, so arranged that each of the further control devices becomes conductive after the first control device located in the opposite arm of the bridge-connected output stage conducts, as the input signal moves away from zero magnitude.

7. A signal amplifier as claimed in any one of claims 1 to 6, including a biassing network arranged to provide set conditions at the amplifier output port at times when the input signal is such that the states of control devices, which form the arms of the bridge, would leave the output conditions indeterminate.

8. A signal amplifier as claimed in claim 7, wherein the biassing network includes a low-level current source located between the higher level supply voltage terminal and the terminals of the output port, and current bleed paths located between the terminals of the output port and the lower level supply voltage terminals.

9. A signal amplifier as claimed in any one of claims 1 to 8, wherein the modulating stage is arranged to provide a current dependent on the input signal magnitude for driving the output stage.

10. A signal amplifier as claimed in any one of claims 1 to 9, wherein the modulating stage includes a first amplifier network arranged to receive an input signal, a second amplifier network arranged to receive a feedback signal from the output stage, and a summing amplifier network arranged to receive the output signals from the first and second amplifier networks.

11. A signal amplifier as claimed in claim 10, wherein the amplifier networks are provided with differential-input ports.

12. A signal amplifier as claimed in claim 10 or claim 11, in which a feedback network is connected between the output stage and the second amplifier network for amplifier bandwidth control.

13. A signal amplifier as claimed in any one of claims 1 to 12, including a voltage monitoring network arranged to monitor the amplifier voltage supply and to control a network for effecting shut-down of the amplifier, the monitoring network being arranged to signal the shut-down network when the voltage supply is below a set value, to effect shut-down of the amplifier.

14. A signal amplifier as claimed in claim 13, including a "retract" network arranged to receive supply energy independently of the amplifier voltage supply and to provide energy directly to the amplifier output port when the voltage monitoring network signals that the voltage supply is below the set value, the "retract" network, in the operation of the amplifier, being capable of returning an actuator to its start position during conditions when the voltage monitoring network is signalling that the voltage supply is below the set value.

15. A signal amplifier as claimed in any one of claims 1 to 12, including a "retract" network arranged to receive supply energy from the amplifier supply voltage and to provide energy directly to the amplifier output port in response to a "retract" command signal, the "retract" network, in the operation of the amplifier, being capable of returning an actuator to its start position in response to the "retract" command signal.

16. A signal amplifier as claimed in claim 15, in which the "retract" network is arranged to also receive supply energy independently of the amplifier voltage supply and to provide energy from the independent supply directly to the amplifier output port in response to the "retract" command signal.

17. A signal amplifier as claimed in any one of claims 14 to 16, wherein the "retract" network is arranged to provide a constant current to the amplifier output port.

18. A signal amplifier as claimed in any one of claims 14 to 16, wherein the "retract" network is arranged to provide a constant voltage at the amplifier output port.

19. A signal amplifier as claimed in any one of claims 1 to 18, including a network arranged to monitor the operating temperature of components of the output stage and to control a network for effecting shut-down of the amplifier, the temperature monitoring network being arranged to signal to the shut-down network when the operating temperature of a component of the output stage exceeds a set level, to effect shut-down of the amplifier.

20. A signal amplifier substantially as herein described with reference to, and as illustrated by, the accompanying drawings.

21. A monolithic integrated circuit including a bridge-connected output stage, a comparator stage, and a modulating stage suitable for constructing a signal amplifier as claimed in any one of claims 1 to 20.

22. A monolithic integrated circuit including a bridge-connected output stage, a comparator stage, a modulating stage, a voltage monitoring network and a shut-down network, suitable for constructing a signal amplifier as claimed in claim 13 or 14.

23. A monolithic integrated circuit including a bridge-connected output stage, a comparator stage, a modulating stage, a voltage monitoring network, a shut-down network, and a "retract" network, suitable for constructing a signal amplifier as claimed in claim 13 or claim 14.

24. A monolithic integrated circuit including a bridge-connected output stage, a comparator stage, a modulating stage, a shut-down network, a "retract" network, and a temperature monitoring network, suitable for constructing a signal amplifier as claimed in claim 20.

**Fig.I.**

Vcc

17

18

15

16

SNUBBER NETWORK

19

20

VOICE COIL

21

OP+

OP-

RS+

RS-

11 SENSE RESISTORS

12

5 OUTPUT POWER STAGE

6 OUTPUT POWER STAGE

10 DISABLE

4 PRE-DRIVER

9 RETRACT DRIVE

8 UNDERVOLTAGE SENSE

7 THERMAL SHUTDOWN

1 V-I CONVERTER OUT + IN -

3 V-I CONVERTER OUT + IN -

13

14 COMPENSATION CAPACITORS

CC-

CC+

GND

VRETR

23

Vcc

5V

RETR

REXT 22

DISBL

VIN+

VIN-

2

FIG.2.

FIG.3.

FIG.4.

FIG.5.

FIG.6.

Vretr

$I_{retr}$ 603

$V_{CC}$

601 2

602 1

$OP^+$

IP3M11

LOAD

36

$OP^-$

## Fig.7.

$V_{CC}$ 5V

703 705 708

$V_{ref}$ 702 704 707

701 706 709

DISABLE

## Fig.8.